Europäisches Patentamt

European Patent Office

Office européen des brevets

(19)

(11) Numéro de publication : **0 170 252 B1**

# FASCICULE DE BREVET EUROPÉEN

(12)

(45) Date de publication du fascicule du brevet :
**27.07.88**

(21) Numéro de dépôt : **85109549.7**

(22) Date de dépôt : **30.07.85**

(51) Int. Cl.⁴ : **C 04 B 41/50, C 23 C 2/00, C 30 B 15/24, C 30 B 15/00, B 05 D 1/18// H01L31/18**

(54) **Procédé et dispositif pour déposer une couche d'un matériau semi-conducteur sur un ruban.**

(30) Priorité : **02.08.84 FR 8412255**

(43) Date de publication de la demande :
**05.02.86 Bulletin 86/06**

(45) Mention de la délivrance du brevet :
**27.07.88 Bulletin 88/30**

(84) Etats contractants désignés :
**BE DE FR GB IT NL**

(56) Documents cités :
**DE-A- 3 215 620**
**GB-A- 2 067 920**
**US-A- 4 299 648**
**DE INGENIEUR, vol. 92, no. 32/33, 6 août 1980, page 34, La Haye, NL; "Polykristallijn silicium voor zonnecellen"**

(73) Titulaire : **COMPAGNIE GENERALE D'ELECTRICITE**
**Société anonyme dite:**
**54, rue La Boétie**
**F-75382 Paris Cédex 08 (FR)**

**SOCIETE NATIONALE ELF AQUITAINE (PRODUC-TION)**
**Tour Elf 2, Place de la Coupole La Défense 6**
**F-92400 Courbevoie (FR)**

(72) Inventeur : **Belouet, Christian**
**138, rue Houdan**
**F-92330 Sceaux (FR)**

(74) Mandataire : **Weinmiller, Jürgen et al**
**Lennéstrasse 9 Postfach 24**
**D-8133 Feldafing (DE)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention concerne un procédé et un dispositif pour déposer une couche d'un matériau semi-conducteur sur un ruban.

Le procédé est d'un type comportant un tirage progressif vertical vers le haut d'un ruban tendu, traversant verticalement dans le sens de sa longueur la surface horizontale d'équilibre d'un bain du matériau semi-conducteur fondu, la couche du matériau semi-conducteur déposée sur les faces du ruban étant raccordée au bain suivant une courbe isotherme de cristallisation.

Dans la mise en œuvre d'un procédé de ce type on constate généralement que l'épaisseur de la couche déposée sur les faces du ruban décroît rapidement lorsqu'on s'approche des deux bords latéraux du ruban. Il en résulte que la couche déposée sur chaque face du ruban présente, le long de ces deux bords latéraux, respectivement deux bandes extrêmes latérales dont les caractéristiques physiques sont détériorées par rapport à celle de la partie médiane de la couche. Ces bandes latérales sont pratiquement inutilisables notamment pour réaliser des photopiles solaires.

Pour pallier cet inconvénient, on a proposé de réaliser un dispositif comportant deux goulottes à section semi-circulaire fixées par des supports s'appuyant sur la paroi d'un creuset contenant le bain. Ces goulottes sont disposées verticalement respectivement de part et d'autre des deux bords latéraux du ruban, la concavité des goulottes étant tournée vers les bords latéraux respectifs du ruban. Ces goulottes sont plongées partiellement dans le bain de façon à élever son niveau par capillarité à proximité des bords latéraux du ruban.

La présente invention a pour but de réaliser un autre dispositif capable de pallier l'inconvénient précité, ce dispositif présentant l'avantage de comporter des moyens de réglage permettant de modifier aisément la forme de la courbe isotherme de cristallisation.

La présente invention a pour objet un procédé pour déposer une couche d'un matériau semi-conducteur sur un ruban, du type mentionné ci-dessus, caractérisé en ce qu'il comporte en outre :

— une première étape qui consiste, avant le tirage, à poser sur ladite surface horizontale d'équilibre une face d'une première plaquette et une face d'une deuxième plaquette, le matériau des plaquettes étant choisi pour que le matériau semi-conducteur fondu adhère à ces faces

— et une deuxième étape qui consiste, après la première étape et avant le tirage, à déplacer chaque plaquette pour la disposer horizontalement à une hauteur prédéterminée au-dessus du bain et à une distance prédéterminée de chaque bord latéral du ruban, de manière à élever localement par capillarité le niveau de la surface horizontale d'équilibre à proximité de chaque bord latéral du ruban et à provoquer sur ces bords pendant le tirage, un relèvement de l'isotherme de cristallisation et une augmentation de l'épaisseur de la couche déposée.

Dans un mode particulier de mise en œuvre de ce procédé, les première et deuxième plaquettes sont déplacées pendant la deuxième étape pour disposer un point central de ces plaquettes dans le plan vertical passant par le ruban.

La présente invention a aussi pour objet un dispositif pour mettre en œuvre le procédé selon l'invention, caractérisé en ce qu'il comporte :

— un creuset contenant un matériau semi-conducteur,

— des moyens de chauffage du creuset pour former dans celui-ci un bain du matériau semi-conducteur fondu,

— des moyens pour tirer progressivement verticalement vers le haut un ruban traversant verticalement, dans le sens de sa longueur, la surface horizontale d'équilibre du bain, de façon à déposer ladite couche sur les faces du ruban

— et des moyens pour déplacer parallèlement à elles-mêmes une première et une deuxième plaquettes au-dessus du bain, ces moyens étant aptes à mettre en contact les faces inférieures de ces plaquettes avec la surface horizontale d'équilibre, puis à disposer chaque plaquette horizontalement à une hauteur prédéterminée au-dessus du bain et à une distance prédéterminée de chaque bord latéral du ruban.

Selon un mode particulier de réalisation du dispositif selon l'invention, les moyens pour déplacer les première et deuxième plaquettes au-dessus du bain comportent deux supports fixés respectivement sur les deux plaquettes et des moyens mécaniques commandables pour déplacer les deux supports indépendamment l'un de l'autre.

Selon un autre mode particulier de réalisation du dispositif selon l'invention, les plaquettes sont en quartz.

Selon un autre mode particulier de réalisation du dispositif selon l'invention, les plaquettes comportent des percées.

Selon un autre mode particulier de réalisation du dispositif selon l'invention, le matériau semi-conducteur est du silicium.

Selon un autre mode particulier de réalisation du dispositif selon l'invention, le ruban est constitué par du carbone.

Des formes particulières d'exécution de l'objet de la présente invention sont décrites ci-dessous, à titre d'exemple, en référence aux dessins annexés dans lesquels :

— la figure 1 est une vue dans l'espace d'un dispositif connu, coupé suivant un plan vertical perpendiculaire au ruban,

— la figure 2 est une vue schématique montrant la forme de l'isotherme de cristallisation du matériau semi-conducteur dans un dispositif du type représenté sur la figure 1,

— la figure 3 est une vue en coupe transversale d'un ruban de carbone revêtu de silicium, obtenu à l'aide d'un dispositif du type représenté sur la figure 1,

— la figure 4 est une vue d'un mode de réalisation du dispositif selon l'invention, dans lequel le creuset est représenté en coupe suivant un plan vertical parallèle au ruban,

— la figure 5 est une vue de dessus, en plan, du dispositif illustré par la figure 4,

— la figure 6 est une vue agrandie en plan montrant une plaquette munie de percées

— et la figure 7 est un schéma montrant différentes formes d'isothermes de cristallisation qu'il est possible d'obtenir à l'aide du dispositif selon l'invention.

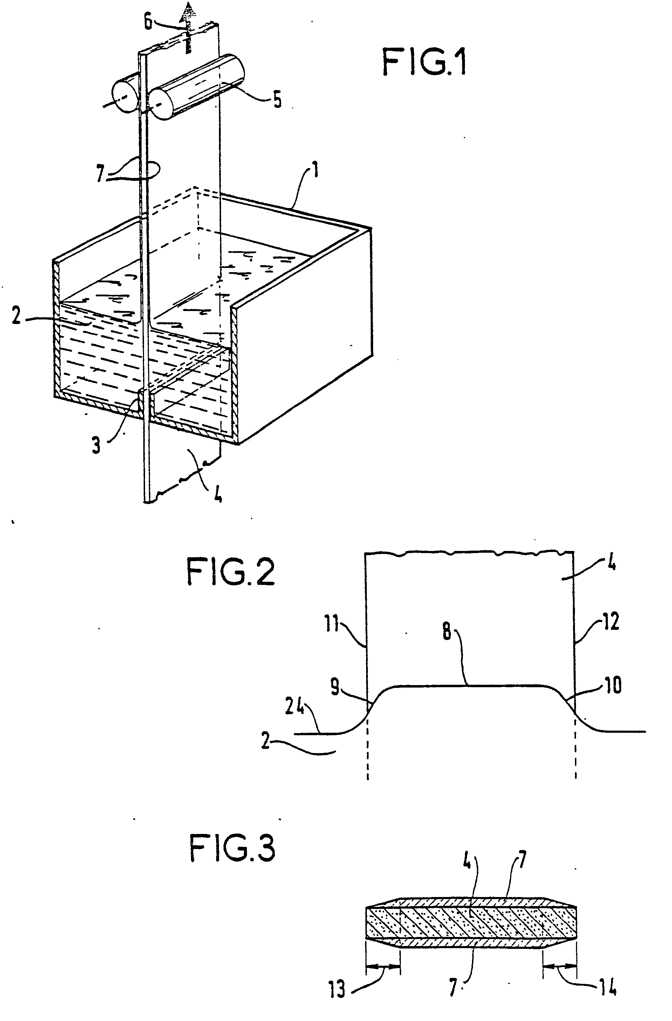

Sur la figure 1, est représenté un creuset parallélépipédique 1 en silice contenant un bain 2 de silicium fondu. Le fond du creuset 1 comporte une fine ouverture linéaire 3 à travers laquelle passe verticalement un ruban de carbone 4 qui sort du bain 2 en traversant sa surface d'équilibre horizontale. La largeur de l'ouverture linéaire est déterminée pour que le ménisque de raccordement du silicium liquide soit stable dans cette ouverture. Bien entendu, le dispositif comporte des moyens de chauffage non représentés disposés autour du creuset 1 pour maintenir le silicium à l'état liquide.

En fonctionnement, lorsque le ruban 4 se déplace dans le sens de la flèche 6, une couche 7 de silicium polycristallin se dépose sur les deux faces du ruban à la sortie du bain.

La figure 2 représente la forme de l'isotherme de cristallisation sur le ruban 4, c'est-à-dire la ligne de raccordement du ménisque de silicium liquide avec la couche de silicium déposée. On voit que dans la partie médiane de la couche, cette ligne est pratiquement un segment de droite 8 horizontal situé au-dessus du niveau 24 du bain. Par contre, dans les deux parties latérales de la couche, cette ligne descend rapidement vers le niveau du bain pour former deux éléments de courbe 9 et 10 dont la concavité est tournée vers le bas.

Il en résulte que l'épaisseur du silicium déposé décroît rapidement lorsqu'on s'approche des bords 11 et 12 du ruban. Cette décroissance est visible sur la figure 3, dans les deux bandes latérales 13 et 14 des deux couches de silicium déposées respectivement sur les deux faces du ruban 4. Lors du refroidissement, des contraintes thermoélastiques, dues aux différences de coefficients de dilatation entre le silicium et le carbone du ruban, se développent dans les couches de silicium. Ces contraintes augmentent lorsque l'épaisseur du silicium décroît. Elles entraînent dans les bandes latérales 13 et 14, la formation de microfractures qui peuvent se propager pendant les opérations de découpe qui suivent habituellement le dépôt des couches.

D'autre part, l'incurvation de la ligne de raccordement dans les bandes latérales détruit l'alignement des grains du silicium, ce qui entraîne une détérioration des propriétés électriques des couches déposées.

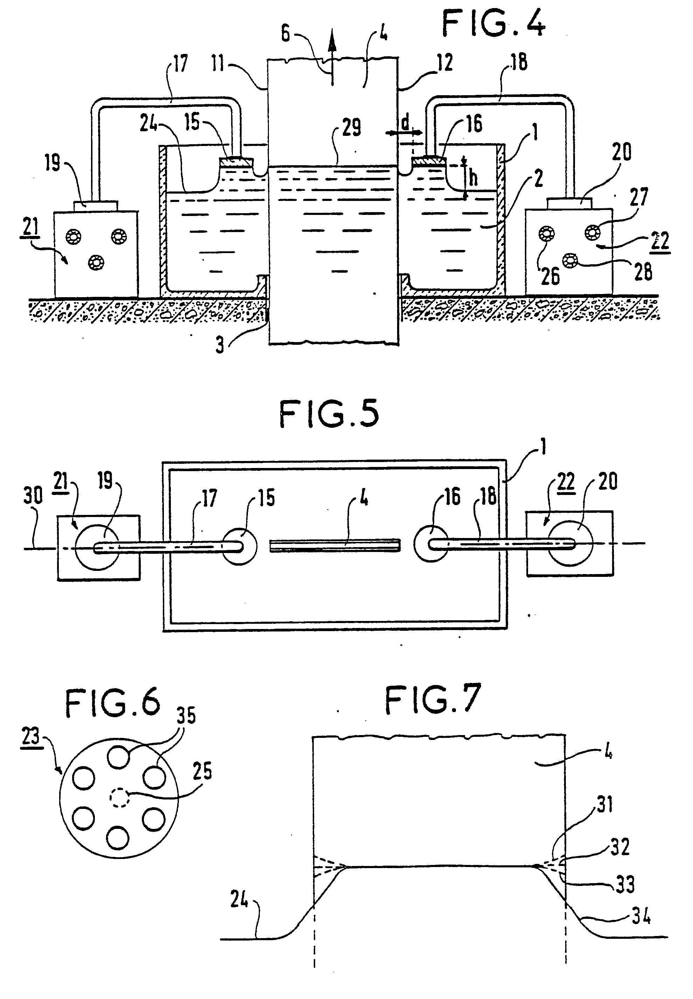

Les éléments des figures 4 et 7 qui sont analogues ou identiques à ceux représentés sur les figures 1 à 3 sont désignés par les mêmes références. Suivant une caractéristique de la présente invention, le dispositif représenté sur les figures 4 et 5 comporte deux plaquettes 15 et 16 disposées horizontalement au-dessus du niveau 24 du bain 2. Ces plaquettes peuvent être par exemple circulaires, de diamètre 8 mm et d'épaisseur 1 mm. Elles sont constituées d'un matériau mouillable par le silicium liquide tel que le quartz, le carbone, le carbure de silicium ou le nitrure de silicium. Chaque plaquette 15, 16 est fixée sur un support. Par exemple, un point central de ces plaquettes est fixé à une extrémité d'une tige 17, 18 en quartz, recourbée en forme de potence. L'autre extrémité de la tige est fixée à la sortie 19, 20 d'un système mécanique 21, 22 capable de commander le déplacement des plaquettes, ce système étant disposé à l'extérieur du creuset 1.

La figure 6 représente à échelle agrandie une plaquette 23 de forme circulaire. La surface de cette plaquette comporte des percées 35 distribuées autour d'un point de fixation central 25.

Le dispositif illustré par les figures 4, 5 et 6 fonctionne de la manière suivante.

Chaque système mécanique tel que 22 comporte trois boutons de réglage 26, 27 et 28. Les boutons 26 et 27 permettent de déplacer l'organe de sortie 20 du système suivant deux directions horizontales perpendiculaires entre elles et le bouton 28 permet de déplacer l'organe 20 suivant la verticale. Les systèmes mécaniques 21 et 22 permettent donc de déplacer les plaquettes 15 et 16 disposées horizontalement suivant les trois directions de l'espace.

L'opérateur agit sur les boutons de réglage des systèmes 21 et 22 de façon que les faces inférieures des plaquettes 15 et 16 viennent affleurer la surface horizontale d'équilibre du bain 2, de part et d'autre des bords latéraux 11 et 12 du ruban 4. Le silicium liquide qui mouille le matériau des plaquettes 15 et 16 adhère aux faces inférieures des plaquettes.

L'opérateur agit ensuite sur le bouton de réglage vertical des systèmes 21 et 22 de façon à soulever les plaquettes 15 et 16 d'une hauteur h au-dessus du niveau 24 du bain. Le silicium liquide continue d'adhérer aux plaquettes par capillarité. Chaque plaquette élève donc localement, de la hauteur h, le niveau de la surface d'équilibre.

Lorsqu'on rapproche les deux plaquettes 15 et 16 respectivement des bords latéraux 11 et 12 du ruban 4 en maintenant la hauteur de soulèvement h, on constate qu'il en résulte un relèvement local de l'isotherme de cristallisation 29 sur les bords 11 et 12. De préférence, les plaquettes 15 et 16 sont disposées de façon que leur point central de fixation soit disposé sensiblement dans le plan vertical 30 défini par le ruban 4.

A titre indicatif, lorsque les plaquettes sont en quartz, la hauteur h peut être comprise entre 0 et 6 mm tandis que la distance d entre le bord de chaque plaquette et le bord latéral du ruban peut être de 2 à 3 mm.

Le relèvement des bords de l'isotherme de cristallisation dépend de la forme extérieure des plaquettes. Lorsque la distance d est fixée à une valeur faible, ce relèvement est d'autant plus important que la hauteur h est grande.

La figure 7 montre différentes formes de courbes isothermes de cristallisation. La courbe 34 indique la forme de l'isotherme obtenue dans l'art antérieur, lorsqu'on n'utilise pas de plaquettes. Sur la courbe 33 obtenue avec des plaquettes maintenues à une faible hauteur au-dessus du bain, les bords de l'isotherme sont relevés par rapport à la courbe 34, mais cette isotherme 33 présente encore une concavité tournée vers le bas. Si l'on augmente la valeur du soulèvement h des plaquettes, on arrive à redresser horizontalement en 32 les bords de l'isotherme. Enfin, si on prévoit un soulèvement des plaquettes au-dessus de la partie rectiligne de l'isotherme, on relève ses bords suivant une courbe 31 présentant une concavité vers le haut. De préférence les plaquettes sont disposées de façon que l'isotherme de cristallisation présente une légère concavité vers le haut.

Après réglage de la position des plaquettes à proximité des bords latéraux 11 et 12, on met en marche le tirage vertical du ruban suivant la flèche 6. La disposition des plaquettes est alors éventuellement ajustée définitivement pour obtenir la forme de courbe de cristallisation souhaitée.

Le dispositif décrit ci-dessus permet non seulement d'obtenir sur les bords latéraux du ruban, une couche de silicium d'épaisseur égale à celle obtenue dans la partie médiane du ruban, mais aussi de renforcer éventuellement l'épaisseur de la couche sur les bords 11 et 12, de façon à diminuer sa fragilité. Cette augmentation d'épaisseur est provoquée par une diminution locale de la température du bain au voisinage des plaquettes. Cette diminution de température est entraînée d'une part par le rayonnement thermique des plaquettes nettement plus important que celui du silicium liquide, et d'autre part par les pertes thermiques par conduction à travers les supports 17 et 18.

Le rayonnement thermique des plaquettes peut être réglé en effectuant des percées 35 plus ou moins nombreuses sur leur surface. Les pertes par conduction peuvent être ajustées en faisant varier par exemple le diamètre des tiges de fixation 17 et 18.

Il est à noter que les percées 35 n'ont pas d'effet sensible sur le relèvement des bords de l'isotherme de cristallisation.

Le procédé et le dispositif selon la présente invention peuvent être appliqués à la réalisation de photopiles solaires au silicium.

## Revendications

1. Procédé pour déposer une couche d'un matériau semi-conducteur sur un ruban, comportant un tirage progressif vertical vers le haut du ruban tendu, traversant verticalement dans le sens de sa longueur la surface horizontale d'équilibre d'un bain du matériau semi-conducteur fondu, la couche du matériau semi-conducteur déposée sur les faces du ruban étant raccordée au bain suivant une courbe isotherme de cristallisation, caractérisé en ce qu'il comporte en outre :

— une première étape qui consiste, avant le tirage, à poser sur ladite surface horizontale d'équilibre une face d'une première plaquette (15) et une face d'une deuxième plaquette (16), le matériau des plaquettes étant choisi pour que le matériau semi-conducteur fondu adhère à ces faces

— et une deuxième étape qui consiste, après la première étape et avant le tirage, à déplacer chaque plaquette (16) pour la disposer horizontalement à une hauteur prédéterminée (h) au-dessus du bain et à une distance prédéterminée (d) de chaque bord latéral (12) du ruban (4), de manière à élever localement par capillarité le niveau de la surface horizontale d'équilibre à proximité de chaque bord latéral du ruban et à provoquer sur ces bords pendant le tirage un relèvement de l'isotherme de cristallisation et une augmentation de l'épaisseur de la couche déposée.

2. Procédé selon la revendication 1, caractérisé en ce que, les première et deuxième plaquettes (15, 16) sont déplacées pendant la deuxième étape pour disposer un point central de ces plaquettes dans le plan vertical (30) passant par le ruban.

3. Dispositif pour mettre en œuvre le procédé selon la revendication 1, caractérisé en ce qu'il comporte :

— un creuset (1) contenant un matériau semi-conducteur,

— des moyens de chauffage du creuset (1) pour former dans celui-ci un bain (2) du matériau semi-conducteur fondu,

— des moyens pour tirer progressivement verticalement vers le haut un ruban (4) traversant verticalement, dans le sens de sa longueur, la surface horizontale d'équilibre du bain (2), de façon à déposer ladite couche sur les faces du ruban

— et des moyens (21, 22) pour déplacer une première et une deuxième plaquettes (15, 16) au-dessus du bain (2), ces moyens étant aptes à mettre en contact les faces inférieures de ces plaquettes avec la surface horizontale d'équilibre, puis à disposer chaque plaquette horizontalement à une hauteur prédéterminée (h) au-dessus du bain, et à une distance prédéterminée (d) de chaque bord latéral du ruban.

4. Dispositif selon la revendication 3, caractérisé en ce que les moyens pour déplacer les première et deuxième plaquettes au-dessus du bain comportent deux supports (17, 18) fixés respectivement sur les deux plaquettes (15, 16) et des moyens mécaniques commandables (21, 22) pour déplacer les deux supports indépendamment l'un de l'autre.

5. Dispositif selon la revendication 3, caractérisé en ce que des plaquettes (15, 16) sont en quartz.

6. Dispositif selon la revendication 3, caractérisé en ce que les plaquettes (23) comportent des percées (35).

7. Dispositif selon la revendication 3, caractérisé en ce que le matériau semi-conducteur est du silicium.

8. Dispositif selon la revendication 3, caractérisé en ce que le ruban (4) est constitué par du carbone.

## Claims

1. A method of depositing a layer of semiconductor material on a ribbon, comprising progressively drawing a taut ribbon vertically upwards, the ribbon passing lengthwise and vertically through the horizontal equilibrium surface of a bath of molten semiconductor material, the layer of semiconductor material deposited on the faces of the ribbon meeting the melt along an isothermal crystallization curve, and being characterized in that it additionally comprises :

a first step which consists, prior to drawing, in disposing one face of a first plate (15) and one face of a second plate (16) on said horizontal equilibrium surface, the plate material being selected so that the molten semiconductor material adheres to said faces ; and

a second step which consists, after the first step and prior to drawing, in displacing each plate (16) to dispose it horizontally at a predetermined height (h) above the melt and at a predetermined distance (d) from each side edge (12) of the ribbon (4), in such a manner as to locally raise the level of the horizontal equilibrium surface by means of capillarity in the proximity of each side edge of the ribbon and to cause the crystallization isotherm to be raised on said edges during drawing and to increase the thickness of the deposited layer.

2. A method according to claim 1, characterized in that the first and second plates (15, 16) are displaced during the second step to dispose a central point of each of said plates in the vertical plane (30) passing through the ribbon.

3. Apparatus for performing the method according to claim 1, characterized in that it comprises :

a crucible (1) containing a semiconductor material ;

crucible (1) heating means for forming a bath (2) of molten semiconductor material therein ;

means for drawing progressively vertically upwardly a ribbon (4) which passes vertically and lengthwise through the horizontal equilibrium surface of the melt (2) in such a manner as to deposit said layer on the faces of the ribbon ; and

means (21, 22) for displacing a first plate and a second plate (15, 16) above the melt (2), said means being suitable for putting the bottom faces of said plates into contact with the horizontal equilibrium surface and then in disposing each plate horizontally at a predetermined height (h) above the melt and at a predetermined distance (d) from each of the side edges of the ribbon.

4. Apparatus according to claim 3, characterized in that the means for displacing the first and second plates above the melt comprise two supports (17, 18) fixed to respective ones of said plates (15, 16) and controllable mechanical means (21, 22) for displacing each support independently from the other.

5. Apparatus according to claim 3, characterized in that the plates (15, 16) are made of quartz.

6. Apparatus according to claim 3, characterized in that the plates (23) include holes (35).

7. Apparatus according to claim 3, characterized in that the semiconductor material is silicon.

8. Apparatus according to claim 3, characterized in that the ribbon (4) is made from carbon.

## Patentansprüche

1. Verfahren zum Aufbringen einer Schicht aus Halbleitermaterial auf einem Band, wobei das gespannte Band fortschreitend vertikal nach oben gezogen wird und dabei der Länge nach den Spiegel eines Bades aus geschmolzenem Halbleitermaterial senkrecht durchquert, und wobei die auf die Bandoberflächen aufgebrachte Schicht aus Halbleitermaterial an das Bad gemäß einer isothermen Kristallisationskurve anschließt, dadurch gekennzeichnet, daß weiter vorgesehen ist :

— ein erster Schritt, in dem vor dem Durchziehen des Bandes durch das Bad eine Fläche einer ersten Scheibe (15) und eine Fläche einer zweiten Scheibe (16) auf den waagerechten Flüssigkeitsspiegel des Bads aufgesetzt werden, wobei das Scheibenmaterial so gewählt ist, daß das geschmolzene Halbleitermaterial an diesen Flächen haftet,

— und ein zweiter Schritt, in dem nach dem ersten Schritt und vor dem Durchziehen des Bandes durch das Bad jede Scheibe (16) so verschoben wird, daß sie waagerecht in einer vorbestimmten Höhe (h) über dem Bad und in einem vorbestimmten Abstand (d) von den Seitenrändern (12) des Bandes (4) liegt, derart, daß örtlich der Pegel des waagerechten Flüssigkeitsspiegels in der Nähe beider Seitenränder des Bandes durch Kapillarkraft ausgehoben wird und an diesen Rändern eine Anhebung der isothermen Kristallisationskurve sowie eine Erhöhung der Dicke der aufgebrachten Schicht erreicht wird.

2. Verfahren nach Anspruch 1, dadurch gekennzeichnet, daß die erste und zweite Scheibe (15, 16) während des zweiten Schritts so verschoben werden, daß ein zentraler Punkt dieser Scheiben in die durch das Band gehende senkrechte Ebene (30) gelangt.

3. Anordnung zur Durchführung des Verfahrens nach Anspruch 1, gekennzeichnet durch :

— einen Schmelztiegel (1), der Halbleitermaterial enthält,

— Mittel zur Beheizung des Schmelztiegels (1), um darin ein Bad (2) aus geschmolzenem Halbleitermaterial zu bilden,

— Mittel zum fortschreitenden, vertikalen Hochziehen eines Bandes (4), das der Länge nach senkrecht den waagerechten Flüssigkeitsspiegel des Bades (2) durchquert, um die genannte Schicht auf die beiden Bandflächen aufzutragen,

— und Mittel (21, 22) zur Verschiebung einer ersten und einer zweiten Scheibe (15, 16) oberhalb des Bades (2), wobei die Mittel gestatten, die unteren Flächen der Scheiben mit dem waagerechten Flüssigkeitsspiegel in Berührung zu bringen, und sie dann waagerecht in eine vorbestimmte Höhe (h) über das Bad und in einen vorbestimmten Abstand (d) zu den Seitenrändern des Bandes zu verschieben.

4. Anordnung nach Anspruch 3, dadurch gekennzeichnet, daß die Mittel zur Verschiebung der ersten und zweiten Scheibe oberhalb des Bades zwei an je einer der Scheiben befestigte Träger (17, 18) sowie steuerbare mechanische Mittel (21, 22) zur Verschiebung der beiden Träger unabhängig voneinander aufweisen.

5. Anordnung nach Anspruch 3, dadurch gekennzeichnet, daß die Scheiben (15, 16) aus Quarz bestehen.

6. Anordnung nach Anspruch 3, dadurch gekennzeichnet, daß die Scheiben (23) Löcher (35) besitzen.

7. Anordnung nach Anspruch 3, dadurch gekennzeichnet, daß das Halbleitermaterial Silicium ist.

8. Anordnung nach Anspruch 3, dadurch gekennzeichnet, daß das Band (4) aus Kohlenstoff besteht.

0 170 252

FIG.1

FIG.2

FIG.3

# FIG.4

# FIG.5

# FIG.6

# FIG.7